# EUROPEAN PATENT SPECIFICATION

(11) **EP 1 504 271 B1**
(45) Date of publication and mention of the grant of the patent: **22.11.2006**
(21) Application number: 02745277.0
(22) Date of filing: 03.05.2002
(51) Int. Cl.: G01R 29/26, H04L 1/20

(54) **SPECTRAL JITTER ANALYSIS**
JITTER-SPEKTRUM-ANALYSE
ANALYSE DE GIGUE SPECTRALE

(43) Date of publication of application: 09.02.2005
(73) Proprietor: Agilent Technologies Deutschland GmbH, 71034 Böblingen (DE)
(72) Inventor: LAQUAI, Bernd, 70597 Stuttgart (DE); MUELLER, Marcus, 70569 Stuttgart (DE)
(74) Representative: Barth, Daniel Mathias
(86) International application number: PCT/EP2002/004841
(87) International publication number: WO 2003/093842

(56) References cited:
- US-A- 4 688 234
- US-A- 5 115 452
- US-A- 5 563 921
- PETERICH D.; HAM B.: 'Methodologies for jitter and signal quality spezification Rev 5' NATIONAL COMITEE FOR INFORMATION TECHNOLOGY STANDARDIZATION 21 February 2002,

## Description

### BACKGROUND OF THE INVENTION

The present invention relates to jitter analysis for digital signals.

Characterization of the transient behavior of high-speed digital circuits, i.e. the transition from a logical zero to a logical one and vice versa, has become increasingly important for designing as well as manufacturing such digital circuits. Timing instabilities such as jitter can cause single transmission errors, or temporary or even permanent outage of an entire communication system, and have to be avoided. The standard overall figure of merit for a communications system is the Bit Error Rate (BER), however a high value of BER does not necessarily indicate timing problems, as there are many other potential sources of error in a system (for example level/threshold mismatch).

One of the key specifications of high-speed circuits with respect to timing is Jitter. ITU-T G.701 defines jitter as short-term non-cumulative variations of the significant instants of a digital signal from their ideal positions in time. The significant instant can be any convenient, easily identifiable point on the signal such as the rising or falling edge of a pulse or the sampling instant. By plotting the relative displacement in the instants between an ideal pulse train and a real pulse train that has some timing jitter, the so-called jitter function is obtained. In addition to the jitter time function, the jitter spectrum can be displayed in the frequency domain. Jitter can also be displayed using so-called Jitter-Histograms showing the likelihood for a transition.

Jitter histograms can be measured using an oscilloscope, a time interval analyzer, or a BER Tester. The applicant Agilent Technologies provides various BER test equipment such as the Agilent® 81250 ParBERT®. The histogram values are obtained from a BER vs. Sample Delay measurement (generally referred to as the so-called bathtub curve) by taking the absolute value of the derivative.

Various ways for jitter analysis are disclosed in the European Patent applications Nos. 02007690.7 or 02006259.2.

US 5,563,921 discloses a jitter detection apparatus for detecting phase variations in a target signal having a certain frequency. The apparatus comprises a phase locked loop with a phase/frequency comparator that outputs an error signal indicative of a phase difference between the target frequency and a loop frequency, a loop filter for low pass filtering the error signal and a jitter detection filter for detecting phase variations in the target signal.

The document "Fibre Channel - Methodologies for Jitter and Signal Quality Specification - MJSQ", Rev 5.0, February 21, 2001 discloses definitions and test methodologies to enable a jitter determination of high speed serial signals.

### SUMMARY OF THE INVENTION

It is an object of the invention to provide an improved jitter analysis. The object is solved by the independent claims. Preferred embodiments are shown by the dependent claims.

According to the present invention, a jitter analysis is provided for a digital signal to be measured having transitions between logical levels. At each of a plurality of successive timing points, a detection for a transition occurring in the signal at that timing point is provided. The result of the detection is compared with an expected signal, and an error value is derived therefrom for each timing point. Each error value represents a matching information between a detected transition (or non-transition) and an expected transition (or non-transition) for the respective timing point.

An error signal is then provided representing the derived error values relative to its respective timing points, or in other words, the error signal represents the plurality of the derived error values, each error value being associated with its respective timing point. The error signal thus shows the variation of the error values, with the variation might be provided over the time (absolute or relative time scale) or any other scale derived from the timing points. Thus, the error signal can be e.g. the derived error values over the plurality of successive timing points. Instead of the plurality of successive timing points, other bases of the error values in the error signal can be derived from the plurality of successive timing points, such as an absolute or relative time scale. Accordingly a pseudo time scale can be provided with the plurality of successive timing points as successive events independent of the actual time difference between successive events. This is in particular useful in case the error values are sampled periodically.

A spectral jitter analysis is then provided for the error signal in order to detect spectral components in the error signal which might represent relevant spectral information of jitter contained in the digital signal. It will be appreciated that substantially any known method for spectral analysis can be applied for the spectral jitter analysis of the error signal, such as auto-correlation, cross-correlation, Fourier-Analysis, etc. Preferred examples for spectral analysis are disclosed e.g. in A. Papoulis: Probability, Random Variables and Stochastic Processes, McGraw Hill 1965, or in J. S. Bendat: A. G. Piersol, Random Data, John Whiley&Sons, 1986. It goes without saying that the specific context of different measurements might render one or more of the known spectral analysis method more or less applicable.

The invention thus allows analyzing the digital signal for spectral components resulting from jitter influences. Such spectral components might then be applied for taking further actions e.g. to avoid or reduce jitter at specific frequencies or for quality checks: Preferred examples are evaluating quantitative presence of known spectral jitter components in the digital signal or a pass/fail test if one or more such known spectral jitter components exceed one or more given thresholds.

The timing points for detecting transitions in the digital signal are preferably selected in ranges wherein transitions are likely (e.g. under the influence of jitter). Preferably, timing points are selected substantially in the middle of such range wherein transitions are likely under the influence of jitter. Such transition ranges can be determined e.g. using known techniques such as the aforementioned Jitter Histograms, bit error rate (BER) measurements, or eye diagram measurements, etc.

In a preferred embodiment wherein transitions in the digital signal are related to a reference signal (e.g. a clock signal) having a reference frequency, the distance between successive timing points is preferably derived from the reference frequency (e.g. as the period, or multiples or fraction thereof, of the reference frequency). The timing points are preferably selected at timings when transitions are expected without influence of jitter, preferably in the middle of a transition area as e.g. determined using an aforementioned eye-diagram.

The transition detection is possible in various ways, preferably by detecting the signal value at a level threshold at a given reference timing point (BER test equipment) or by evaluating the sampled signal waveform (Oscilloscope).

The invention can be partly or entirely embodied or supported by one or more suitable software programs, which can be stored on or otherwise provided by any kind of data carrier, and which might be executed in or by any suitable data processing unit. The invention may also be partly or entirely embodied or supported by dedicated electronic hardware not related to software or firmware execution such as an hardwired ASIC. Accordingly, combinations of software and hardware solutions might also be employed.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference sign(s).
- Figs. 1-3: illustrate an embodiment with sinusoidal jitter modulation onto a random digital data signal.
- Figs. 4-7: illustrate an embodiment with sinusoidal jitter modulation and random jitter content onto a random digital data signal.

### DETAILED DESCRIPTION OF EMBODIMENTS OF THE INVENTION

For validation and characterization of digital circuit designs, it is of advantage not only to quantify the amount of jitter measured but also to analyze it for its spectral content to localize its origin and understand the mechanisms of interference. In order to allow elimination or reduction of deterministic jitter in a design, the generated jitter is analyzed for its deterministic content by decomposing it into its spectral contents. Whereas the energy of random jitter modulation is generally spread into wide frequency band, deterministic jitter usually manifests itself with a concentration of energy into (e.g. a few) discrete modulation frequencies. The ability to determine those frequencies might provide insight into root causes and can therefore significantly speed up the debugging process.

In the following, preferred embodiments are described for providing spectral analysis on jitter measured with a bit error rate tester (BERT) such as the aforementioned Agilent® 81250 ParBERT®. However, it is clear that the invention is not limited to BERTs, but that any other test equipment can be provided for deriving the error signal from comparing detected with expected transitions at defined timing points or sampling and evaluating the entire signal waveform.

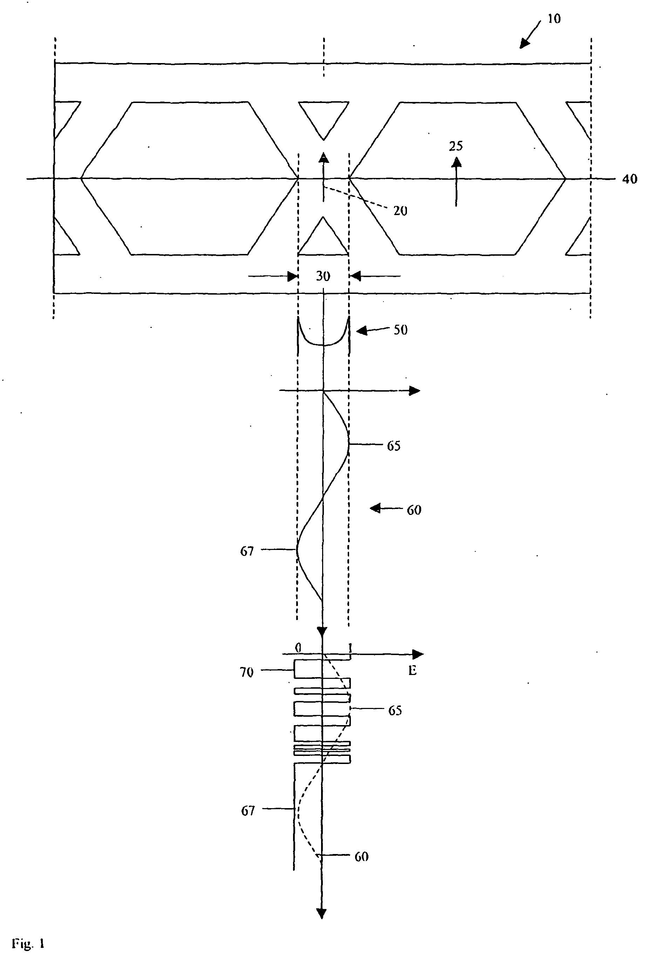

Fig. 1 illustrates principles of a preferred embodiment. The upper part shows a typical eye diagram 10 with a plurality of transitions superimposed. For the sake of clarity, only the 'borders' of superimposed lines are shown. A sampling point 20 is selected to be within a transition range 30 determined by all detected transitions occurring at a given threshold level 40. Preferably, the sampling point 20 is selected substantially in the middle of the transition range 30 for a given threshold level 40 of substantially 50%. The sampling point 20 might also be selected using a Jitter Histogram 50, and is preferably selected at the center of gravity of the Jitter Histogram 50.

At the sampling point 20, strobing is provided by comparing each detected signal value with the value expected in the 'center' of the data eye (e.g. in the eye to the right, indicated by a reference timing point 25). Whenever a transition is displaced such that the data eye closes (displacement to the right in the eye diagram 10 of Fig. 1), the strobing will result in an error.

For the sake of better understanding, a sinusoidal jitter modulation 60 onto a random digital data signal shall be assumed. While the random data signal allows an easier explanation, it is clear that the invention can be applied for any kind of digital signal. Without the jitter modulation 60, all transitions of the digital data signal would occur precisely at the sampling point 20. However, the jitter modulation 60 will periodically displace the transitions of the digital data signal 'around' the sampling point 20, thus leading to the transition range 30. Just from looking at the jitter histogram 50, no conclusion can be made on the frequency of the jitter modulation 60.

Whenever the jitter modulation 60 displaces the transitions to the right in Fig. 1 and comparison is performed e.g. to the value as expected at the reference timing point 25 of the right data eye center, the strobing will result in errors. Due to the displacement of the transitions, the value of the left data bit is actually compared to what is expected at the reference timing point, thus resulting in an error.

Since we assume random data, the BER will be 0.25, because in 50% of the cases during the positive portion 65 of the jitter modulation sine wave 60 adjacent bits are equal in value and no transition will occur between the sampled and the expected bit. Thus the jitter has no impact on that particular bit. In contrary, when the displacement is opposite (i.e. during the negative portion 67 of the jitter modulation sine wave 60 no error will occur. No error occurs, because the data eye to the right is opened by the displacement (displacement to the left in Fig 1) which allows to sample the expected value despite the offset of the current sampling point 20 to the reference data point 25. Thus, the error signal 70 (with the errors E depicted over the time) is modulated in its error density according to the jitter frequency of the jitter modulation 60.

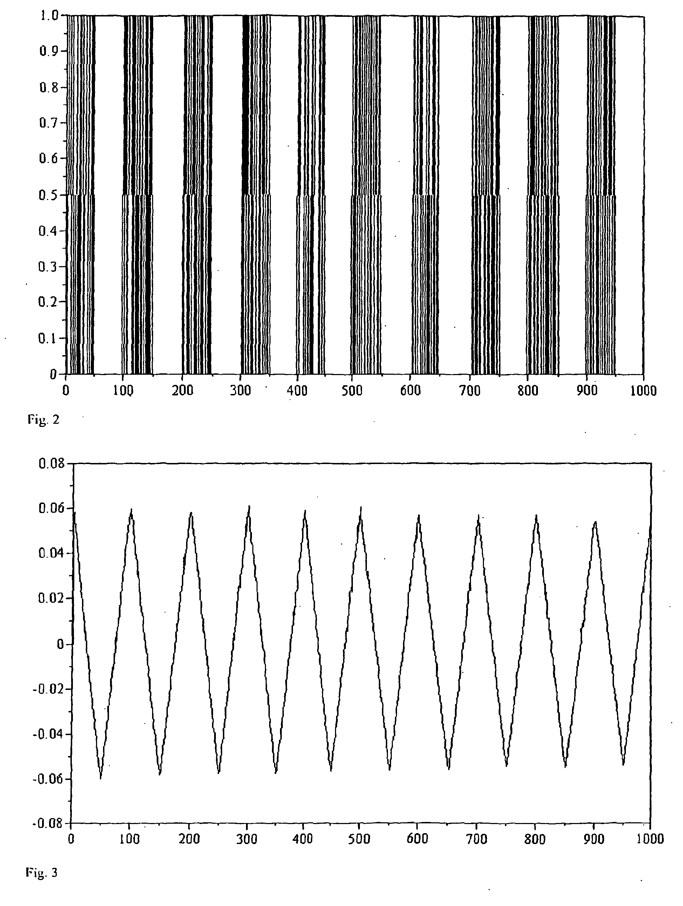

Fig. 2 shows the result of a simulation of what is shown schematically in Fig. 1. Fig. 2 represents the logical values (represented by 0 and 1) of the generated error signal 70 over the time. The error signal 70 shows a periodic modulation of the error density. The periodicity appears as a segment with zero errors followed by a segment with 50% errors.

A well-know statistical method to extract periodic information buried in a random signal is the calculation of the auto-correlation function (as illustrated in more detail e.g. in the aforementioned references by Papoulis or Bendat). The auto-correlation function of a true random signal vanishes after a small bandwidth related delay, whereas any kind of periodic signal yields an auto-correlation function with the same periodicity that does not vanish even for large delays. Therefore the periodic information can be extracted from the auto-correlation function by evaluating the behavior for large delays. Fig. 3 shows the auto-correlation function of the error signal as shown in Fig. 2. Fig. 3 depicts the value of the auto-correlation versus the correlation delay. The jitter frequency of the jitter modulation 60 can then be derived by evaluating the periodicity of the auto-correlation function, preferably by calculation of its Fourier transform. According to the Theorem of Wiener-Chintchine (as also illustrated in more detail e.g. in the aforementioned references by Papoulis or Bendat), the Fourier transform of the auto-correlation function represents the spectral power density of the error signal. Since the error signal reflects the periodicity of the jitter, the obtained spectrum represents the spectral information caused by the jitter modulation.

An alternative way to obtain the same spectral information is by directly calculating the Fourier transform of the error signal. The obtained (complex) values of the Fourier transform may then be multiplied with its conjugate complex values. The result is the same spectral power density of the error signal as obtained by calculating the Fourier transform of the auto-correlation function.

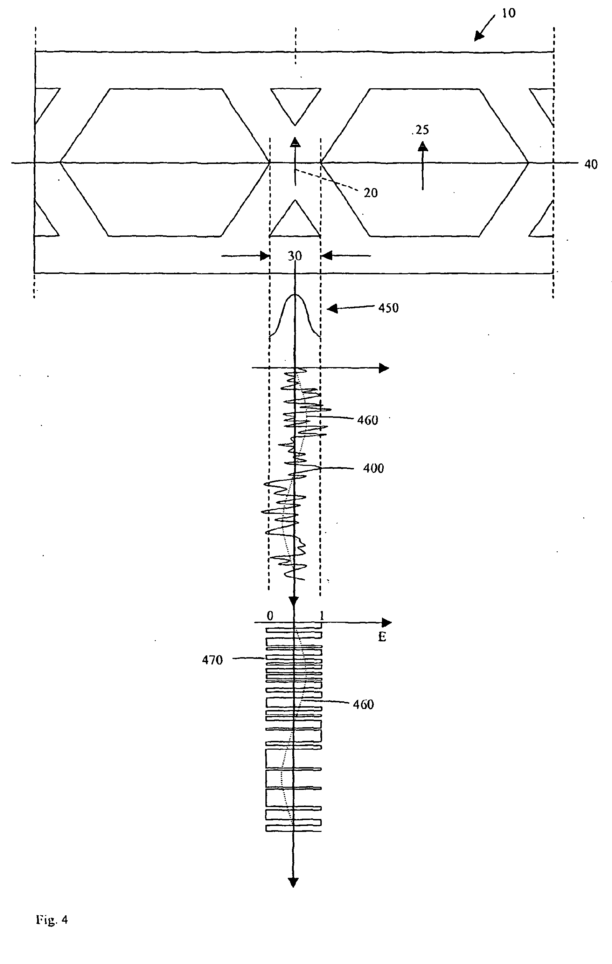

Pure sinusoidal jitter rarely occurs in reality. Typically real systems show intrinsic random jitter caused by thermal and scattering noise. Since it is the result of many different uncorrelated contributors the intrinsic random jitter generally shows up with a Gaussian distribution. An example where sinusoidal jitter artificially injected and intrinsic random noise is mixed is shown in Fig. 4.

As long as the peak-to-peak amplitude of the sinusoidal jitter 460 (dotted line) does not substantially exceed the rms value of the random jitter 400, the distribution of the composite jitter in the Jitter Histogram 450 still shows up with a bell like distribution that makes separation of sinusoidal and random jitter difficult.

When random and sinusoidal jitter are mixed and the sinusoidal jitter 460 does not exceed the random jitter 400 by far, the error signal 470 generated by sampling in the sampling point 20 (here: crossover point of the transitions) again shows up with a periodic modulation of the error density. The difference to the pure sinusoidal jitter (as depicted in Fig. 1) is that now the negative portion of the sinusoid also generates errors but with smaller density than during the positive portion. Therefore the periodicity of the sinusoidal jitter 460 gets transferred in a similar way into the error signal 470 and can be extracted e.g. by calculation of the auto-correlation function or the spectral density function.

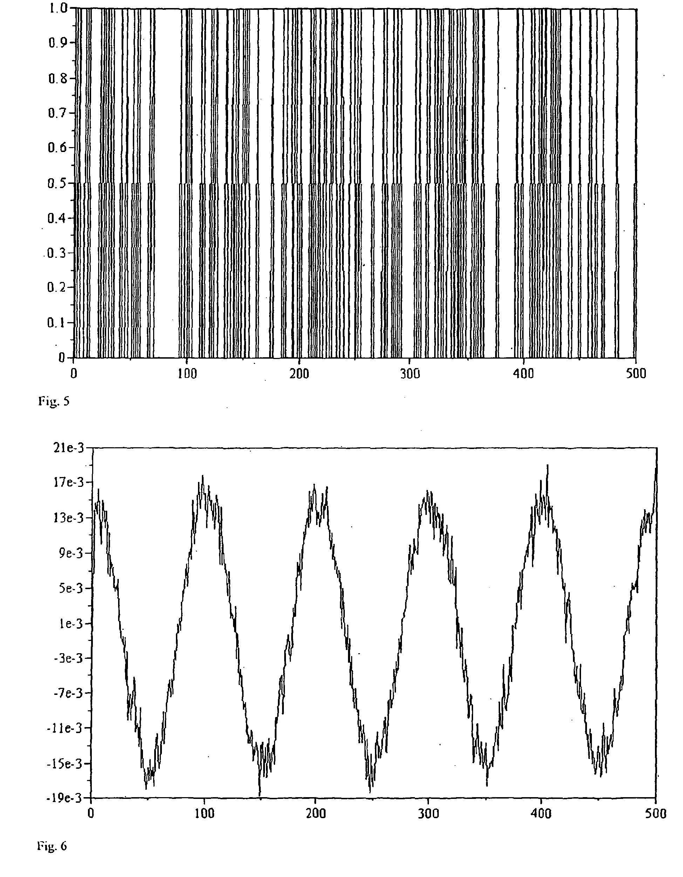

Fig. 5 shows a simulated error signal 470 caused by sinusoidal and random jitter. The periodicity in the error density is hardly visible and the signal appears to have a random character.

Fig. 6 shows the auto-correlation function calculated from the error signal as shown in Fig. 5. Due to the fact that it is calculated on a limited sample set the result shows a certain noise. By increasing the sample set, however, the amplitude of this noise can be reduced. The auto-correlation function clearly shows the periodic signal buried in the error signal. Thus a more linear mapping of the jitter modulation 460 into the error signal 470 can be achieved. Since the error density is modulated more smoothly in an analog way the auto-correlation function fully represents the sinusoidal jitter modulation with the respective periodicity.

Since a broadband noise signal represents a continuous flat power density spectrum, the energy is equally distributed over a wide range of frequencies and thus is typically small in magnitude in a narrow section of the spectrum. In contrary when a periodic signal is contained in a broadband noise signal the power density of the periodic signal is strongly concentrated in few discrete lines and can clearly be distinguished from the broadband noise power density.

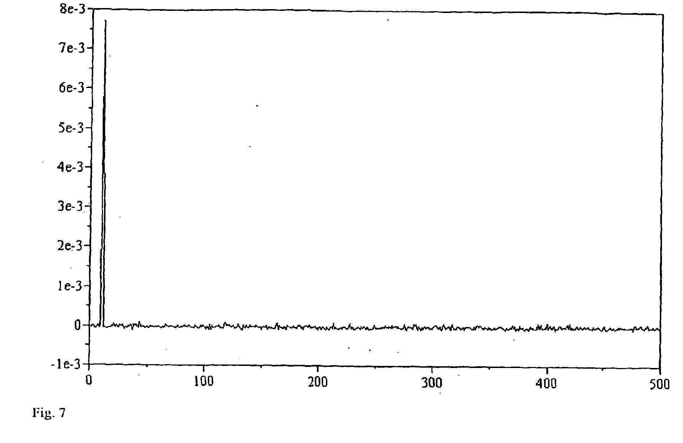

Therefore, when the Fourier transform is deployed to the auto-correlation of the error signal caused by both random and sinusoidal jitter, the resulting power density spectrum shows the spectral information of the sinusoid in terms of a strong peak. The result of the respective simulation is shown in Fig. 7, with the frequency of the sinusoidal modulation 460 appearing as a peak.

The fact that the power density of the random portion gets distributed over many frequencies while the spectral power of the sinusoidal portion stays concentrated in a single line significantly enhances the detection of spurious periodic jitter deeply buried in random jitter. Thus even small sources of deterministic jitter can be identified.

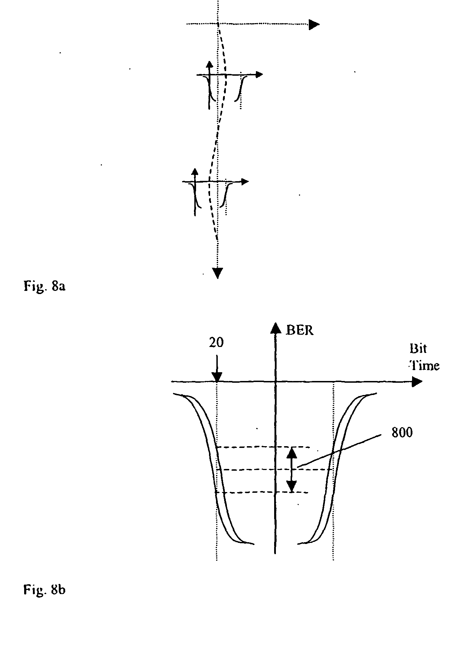

The influence of the position of the sampling point 20 is explained schematically in more detail in Figs. 8A and B. The distribution of a composite jitter modulation signal consisting of random and sinusoidal jitter on the error rate can be perceived as a sinusoidally shifted Gaussian distribution. This means also that a virtual purely random BER curve is moving sinusoidally left and right on the bit time axis (x-axis in Fig. 8B) due to the sinusoidal component. Therefore the depth of error density modulation 800 depends on the steepness of the BER curve at the strobe point (the sampling point 20) provided the sinusoidal component is small. From this consideration follows that the optimum sensitivity can be obtained with the sampling point 20 offset by 0.5UI (UI = Unit Interval) from the data eye center (as shown in Figs. 1 and 4) or respectively from the center of gravity of the jitter histogram.

The aforedescribed ways to analyze composite jitter containing deterministic (periodic) and random jitter and to decompose it into its spectral components, has been shown particularly useful for design validation and debugging when the jitter frequencies of the deterministic portions are unknown.

In case, however, when it is already known or expected that a problem caused by deterministic jitter of a well-known frequency may exist, a pass/fail test might be provided useful e.g. for production testing. A typical case might be e.g. when process variations or other manufacturing defects result in jitter crosstalk from a known source. Such pass/fail test might be applied in a production test-flow to test for the occurrence of such faults for the deterministic jitter.

In one embodiment to determine the existence of a jitter with known frequency for pass/fail testing or to quantify jitter of a known frequency contained in a mix of random and deterministic jitter, a cross-correlation function (or covariance) is determined between the error signal and a sine wave of the expected frequency. Alternatively, another deterministic signal representing the potentially occurring jitter frequency can be used instead of a pure sine wave for calculating the cross-correlation. In case the deterministic signal is contained with the given frequency in the error signal and thus in the composite jitter of the data signal, the cross-correlation function will show up with a strong signal of the expected frequency. A Fourier transform of the cross-correlation signal may then show a strong peak at that frequency. When it is not contained in the composite jitter the cross-correlation function will show only a negligible signal induced by the noise and thus the Fourier transform will only show a minimal excitation.

## Claims

1. A method for providing a jitter analysis for a digital signal having transitions between logical levels, the method comprising the steps of:
(a) receiving a plurality of error values, each error value being associated with one of a plurality of successive timing points (20), the timing points (20) being selected in ranges (30) wherein transitions are likely, and each error value being derived from a comparison of a result of a detection for a transition occurring in the digital signal at its associated timing point (20) with an expected signal,
(b) providing an error signal (70) representing the derived error values relative to their respective timing points (20), and
(c) providing a spectral jitter analysis for the error signal (70) in order to detect spectral components in the error signal (70).

2. The method of claim 1, further comprising prior to step (a) the steps of:
- providing, at each one of the plurality of successive timing points (20), a detection for a transition occurring in the signal at that timing point (20), and
- for each one of the plurality of successive timing points (20), comparing a result of the detection with an expected signal and deriving the error value therefrom.

3. The method of claim 1 or any one of the above claims, wherein step (c) comprises at least one of: applying an auto-correlation, a cross-correlation, or a Fourier-Analysis to the error signal (70).

4. The method of claim 1 or any one of the above claims, wherein each error value represents a matching information between a detected transition or non-transition and an expected transition or non-transition for the respective timing point (20).

5. The method of claim 1 or any one of the above claims, wherein the error signal (70) represents the plurality of the derived error values, each error value being associated with its respective timing point (20).

6. The method of claim 1 or any one of the above claims, wherein the error signal (70) represents the variation of the error values over the time or any other scale derived from the timing points (20).

7. The method of claim 1 or any one of the above claims, further comprising a step of evaluating a quantitative presence of a spectral jitter component in the digital signal.

8. The method of claim 7, further comprising a step of providing a pass/fail test by comparing the evaluated quantitative presence of the spectral jitter component with a given threshold value.

9. The method of claim 8, wherein the pass/fail test fails, if the evaluated quantitative presence of the spectral jitter component exceeds the given threshold value.

10. The method of claim 1, wherein the timing points (20) are selected substantially in the middle of such ranges wherein transitions are likely under the influence of jitter.

11. The method of claim 1 or any one of the above claims, wherein transitions in the digital signal are related to a reference signal having a reference frequency, a distance between successive timing points (20) is derived from the reference frequency.

12. A software program or product, preferably stored on a data carrier, for executing all the steps of the method of claim 1 or any one of the above claims when run on a data processing system such as a computer.

13. An apparatus for providing a jitter analysis for a digital signal having transitions between logical levels, comprising:
a detector adapted for providing, at each one of a plurality of successive timing points (20), a detection for a transition occurring in the digital signal at that timing point (20), the detector being adapted for selecting the timing points (20) in ranges (30) wherein transitions are likely,
a comparator adapted for comparing, for each one of the plurality of successive timing points (20), a result of the detector with an expected signal and deriving an error value therefrom,
a signal generation unit being adapted for generating an error signal (70) representing the derived error values relative to their respective timing points (30), and
an analysis unit being adapted for providing a spectral jitter analysis for the error signal (70) in order to detect spectral components in the error signal (70).

## Patentansprüche

1. Verfahren zum Bereitstellen einer Jitter-Analyse (Impulszittern) für ein digitales Signal mit Übergängen zwischen Logikpegeln, wobei das Verfahren die folgenden Schritte umfasst:
(a) Empfangen einer Vielzahl von Fehlerwerten, wobei jeder Fehlerwert einem aus einer Vielzahl aufeinander folgender Zeitpunkte (20) zugeordnet ist, die Zeitpunkte (20) aus Bereichen (30) ausgewählt werden, in denen Übergänge zu erwarten sind, und jeder Fehlerwert aus einem Vergleich zwischen einem Erkennungsergebnis für einen in dem digitalen Signal an seinem zugehörigen Zeitpunkt (20) entstehenden Übergang und einem erwarteten Signal abgeleitet wird,
(b) Bereitstellen eines Fehlersignals (70), das die abgeleiteten Fehlerwerte in Bezug auf ihre entsprechenden Zeitpunkte (20) darstellt, und
(c) Bereitstellen einer spektralen Jitter-Analyse für das Fehlersignal (70) zum Erkennen von spektralen Komponenten im Fehlersignal (70).

2. Verfahren nach Anspruch 1, das vor dem Schritt (a) femer die folgenden Schritte umfasst:
- Bereitstellen einer Erkennung eines zu diesem Zeitpunkt (20) im Signal eintretenden Übergangs an jedem aus der Vielzahl aufeinander folgender Zeitpunkte (20), und
- Vergleichen eines Erkennungsergebnisses für jeden aus der Vielzahl aufeinander folgender Zeitpunkte (20) mit einem erwarteten Signal und Ableiten des Fehlerwertes aus dem Vergleich.

3. Verfahren nach Anspruch 1 oder einem der obigen Ansprüche, bei welchem der Schritt (c) mindestens einen der folgenden Schritte umfasst: Ausführen einer Autokorrelation, einer Kreuzkorrelation oder einer Fourieranalyse des Fehlersignals (70).

4. Verfahren nach Anspruch 1 oder einem der obigen Ansprüche, bei welchem jeder Fehlerwert eine Vergleichsinformation zwischen einem erkannten Übergang oder Nichtübergang und einem erwarteten Übergang oder Nichtübergang für den betreffenden Zeitpunkt (20) darstellt.

5. Verfahren nach Anspruch 1 oder einem der obigen Ansprüche, bei welchem das Fehlersignal (70) die Vielzahl der abgeleiteten Fehlerwerte darstellt, wobei jeder Fehlerwert seinem entsprechenden Zeitpunkt (20) zugeordnet ist.

6. Verfahren nach Anspruch 1 oder einem der obigen Ansprüche, bei welchem das Fehlersignal (70) die Schwankungen der Fehlerwerte über der Zeit oder über einer anderen von den Zeitpunkten (20) abgeleiteten Skala darstellt.

7. Verfahren nach Anspruch 1 oder einem der obigen Ansprüche, das femer einen Schritt zur Bewertung eines quantitativen Auftretens einer spektralen Jitter-Komponente im digitalen Signal umfasst.

8. Verfahren nach Anspruch 7, das femer einen Schritt zum Bereitstellen einer Pass/Fail-Prüfung durch Vergleichen des bewerteten quantitativen Auftretens der spektralen Jitter-Komponente mit einem vorgegebenen Schwellenwert umfasst.

9. Verfahren nach Anspruch 8, bei welchem das Ergebnis der Pass/Fail-Prüfung negativ ist, wenn das bewertete quantitative Auftreten der spektralen Jitter-Komponente den vorgegebenen Schwellenwert überschreitet.

10. Verfahren nach Anspruch 1, bei welchem die Zeitpunkte (20) im Wesentlichen aus der Mitte von Bereichen ausgewählt werden, in denen durch Jitter beeinflusste Übergänge zu erwarten sind.

11. Verfahren nach Anspruch 1 oder einem der obigen Ansprüche, bei welchem Übergänge im digitalen Signal zu einem Referenzsignal mit einer Referenzfrequenz in Beziehung gesetzt werden und aus der Referenzfrequenz ein Abstand zwischen aufeinanderfolgenden Zeitpunkten (20) abgeleitet wird.

12. Softwareprogramm oder -produkt, das vorzugsweise auf einem Datenträger gespeichert ist, zum Ausführen aller Schritte des Verfahrens nach Anspruch 1 oder einem der obigen Ansprüche, wenn die Software auf einem Datenverarbeitungssystem wie beispielsweise einem Computer läuft.

13. Vorrichtung zum Bereitstellen einer Jitter-Analyse für ein digitales Signal mit Übergängen zwischen Logikpegeln, wobei die Vorrichtung Folgendes umfasst:
einen Detektor, der in der Lage ist, ein Erkennen eines zu einem bestimmten Zeitpunkt (20) in dem digitalen Signal eintretenden Übergangs zu jedem aus einer Vielzahl aufeinander folgender Zeitpunkte (20) bereitzustellen, wobei der Detektor die Zeitpunkte (20) aus Bereichen (30) auswählen kann, in denen Übergänge zu erwarten sind,
einen Komparator, der in der Lage ist, ein Ergebnis des Detektors mit einem erwarteten Signal zu vergleichen und einen Fehlerwert aus dem Vergleich für jeden aus der Vielzahl aufeinander folgender Zeitpunkte (20) abzuleiten,
eine Signalerzeugungseinheit, die in der Lage ist, ein Fehlersignal (70) zu erzeugen, das die abgeleiteten Fehlerwerte in Bezug auf ihre entsprechenden Zeitpunkte (20) darstellt, und
eine Analyseeinheit, die in der Lage ist, eine spektrale Jitter-Analyse für das Fehlersignal zu erstellen, um spektrale Komponenten im Fehlersignal (70) zu erkennen.

## Revendications

1. Procédé destiné à délivrer une analyse de gigue d'un signal numérique présentant des transitions entre des niveaux logiques, le procédé comprenant les étapes consistant à :
(a) recevoir une pluralité de valeurs d'erreurs, chaque valeur d'erreur étant associée à l'un d'une pluralité de points temporels successifs (20), les points temporels (20) étant sélectionnés dans des plages (30) dans lesquelles des transitions sont probables, et chaque valeur d'erreur étant dérivée d'une comparaison d'un résultat de détection d'une transition se produisant dans le signal numérique à son point temporel associé (20) à un signal prévu,
(b) délivrer un signal d'erreur (70) représentant les valeurs d'erreur dérivées par rapport à leurs points temporels respectifs (20), et
(c) délivrer une analyse de gigue spectrale du signal d'erreur (70) afin de détecter des composantes spectrales dans le signal d'erreur (70).

2. Procédé conforme à la revendication 1, comprenant en outre avant l'étape (a) les étapes consistant à :
- délivrer, à chacun de la pluralité de points temporels successifs (20), une détection de transition se produisant dans le signal à ce point temporel (20), et
- pour chacun de la pluralité de points temporels successifs (20), comparer un résultat de la détection à un signal prévu et dériver la valeur d'erreur à partir de celui-ci.

3. Procédé conforme à la revendication 1 ou à l'une des revendications précédentes, **caractérisé en ce que** l'étape (c) comprend au moins l'une parmi : l'application d'une auto-comélation, d'une corrélation croisée ou d'une analyse de Fourier au signal d'erreur (70).

4. Procédé conforme à la revendication 1 ou à l'une des revendications précédentes, **caractérisé en ce que** chaque valeur d'erreur représente une information de correspondance entre une transition détectée ou une non-transition et une transition prévue ou une non-transition pour le point temporel respectif (20).

5. Procédé conforme à la revendication 1 ou à l'une des revendications précédentes, **caractérisé en ce que** le signal d'erreur (70) représente la pluralité de valeurs d'erreurs dérivées, chaque valeur d'erreur étant associée à son point temporel respectif (20).

6. Procédé conforme à la revendication 1 ou à l'une des revendications précédentes, **caractérisé en ce que** le signal d'erreur (70) représente la variation des valeurs d'erreurs dans le temps ou une quelconque autre échelle dérivée des points temporels (20).

7. Procédé conforme à la revendication 1 ou à l'une des revendications précédentes, comprenant en outre une étape d'évaluation d'une présence quantitative d'une composante de gigue spectrale dans le signal numérique.

8. Procédé conforme à la revendication 7, comprenant en outre une étape de réalisation d'un test réussite/échec en comparant la présence quantitative évaluée de la composante de gigue spectrale à une valeur de seuil donnée.

9. Procédé conforme à la revendication 8, **caractérisé en ce que** le test réussite/échec échoue si la présence quantitative évaluée de la composante de gigue spectrale dépasse la valeur de seuil donnée.

10. Procédé conforme à la revendication 1, **caractérisé en ce que** les points temporels (20) sont sélectionnés sensiblement au milieu de telles plages dans lesquelles des transitions sont probables sous l'influence de la gigue.

11. Procédé conforme à la revendication 1 ou à l'une des revendications précédentes, **caractérisé en ce que** des transitions dans le signal numérique sont liées à un signal de référence présentant une fréquence de référence, une distance entre des points temporels successifs (20) est dérivée de la fréquence de référence.

12. Programme ou produit logiciel, de préférence stocké sur un support de données, destiné à exécuter l'ensemble des étapes du procédé conforme à la revendication 1 ou à l'une des revendications précédentes lorsque exécuté sur un système de traitement de données tel qu'un ordinateur.

13. Dispositif destiné à délivrer une analyse de gigue d'un signal numérique présentant des transitions entre des niveaux logiques, comprenant :
un détecteur adapté pour délivrer, à chacun d'une pluralité de points temporels successifs (20), une détection de transition se produisant dans le signal numérique à ce point temporel (20), le détecteur étant adapté pour sélectionner les points temporels (20) dans des plages (30) dans lesquelles des transitions sont probables,
un comparateur adapté pour comparer, pour chacun d'un de la pluralité de points temporels successifs (20), un résultat du détecteur à un signal prévu et pour dériver une valeur d'erreur à partir de celui-ci,
une unité de génération de signal étant adaptée pour générer un signal d'erreur (70) représentant les valeurs d'erreurs dérivées par rapport à leurs points temporels respectifs (30), et
une unité d'analyse étant adaptée pour délivrer une analyse de gigue spectrale du signal d'erreur (70) afin de détecter des composantes spectrales dans le signal d'erreur (70).
